# EUROPÄISCHE PATENTSCHRIFT

(11) **EP 4 450 981 B1**
(45) Veröffentlichungstag und Bekanntmachung des Hinweises auf die Patenterteilung: **11.06.2025**
(21) Anmeldenummer: 23169015.7
(22) Anmeldetag: 20.04.2023
(51) Int. Cl.: G01R 27/18, H02H 3/16, H02H 9/08

(54) **ANORDNUNG MIT EINEM ISOLATIONSWÄCHTER FÜR EIN IT-SYSTEM**
ARRANGEMENT WITH AN INSULATION MONITORING DEVICE FOR AN UNGROUNDED IT POWER SUPPLY SYSTEM
DISPOSITIF AVEC UN CONTRÔLEUR D'ISOLATION POUR UN SYSTÈME ISOLÉ-TERRE

(43) Veröffentlichungstag der Anmeldung: 23.10.2024
(73) Patentinhaber: Siemens Aktiengesellschaft, 80333 München (DE)
(72) Erfinder: Lange, Robert, 08451 Crimmitschau (DE)
(74) Vertreter: Siemens Patent Attorneys

(56) Entgegenhaltungen:
- EP-A1- 3 620 800
- EP-A1- 3 862 763
- EP-A1- 4 089 423
- EP-B1- 1 845 548
- CN-U- 209 198 598
- CN-U- 209 673 895
- DE-B4- 102011 055 371
- DE-C- 722 348
- FR-A1- 2 976 084
- US-A- 3 975 663
- US-A- 4 375 660
- US-A1- 2016 336 732
- US-A1- 2020 110 125

## Beschreibung

Die vorliegende Erfindung betrifft eine Anordnung mit einem Isolationswächter für ein IT-System und einem Entladewiderstand zur Entladung einer Erd-Ableitkapazität des IT-Systems.

Elektrische Netze ohne galvanische Verbindung zwischen aktiven Leitern und geerdeten Teilen werden als IT-Netze oder IT-Systeme (französisch: Isolé Terre) oder auch als isoliertes Netz bezeichnet. In IT-Netzen werden zur Erhöhung der Anlagenverfügbarkeit sogenannte Isolationswächter eingesetzt. In Isolationswächtern lässt sich zu diesem Zweck eine maximal wirksame Kapazität oder (Erd-)Ableitkapazität und ein Ableitwiderstand einstellen.

IT-Systeme finden Verwendung in meist kleinräumigen Industrienetzen und in Krankenhäusern. In diesen Netzen ist der Sternpunkt nicht geerdet. Daher führt ein einfacher Erdschluss nicht sofort zu einem Netzausfall und kann gegebenenfalls im laufenden Betrieb behoben werden. Das Isolationsüberwachungsgerät zeigt dann den Fehler an, verursacht von einem Blindstrom an der Fehlerstelle. Die Höhe des Blindstroms ist von der Erdableitkapazität des IT-Netzes abhängig. Beim Betrieb von Umrichtern und Netzteilen im IT-Netz sollten die gegen Erde (PE) wirkenden Kapazitäten und Ableitströme daher bevorzugt gering sein.

Der bekannte Stand der Technik, von dem die Erfindung ausgeht, betrifft eine Anordnung mit einem Isolationswächter gemäß dem Oberbegriff des Anspruchs 1. Aus der DE722348C ist beispielsweise bereits eine Isolationsüberwachungs- und Erdschluss-Anzeigeeinrichtung für Drehstromanlagen bekannt, bei welcher mindestens eine der Phasen und ein Sternpunkt über Widerstände beliebiger Phasenlage, jedoch von etwa der gleichen Größenordnung wie die Absolutwerte der normalen komplexen Ableitwiderstände der zu überwachenden Anlage gegen Erde, in einem gemeinsamen Punkt verbunden und an Erde gelegt sind, wobei der in der gemeinsamen Erdleitung fließende Strom zur Erfassung von Erdschlüssen oder, bei gesundem Netz, als ungefähres Maß für die komplexen Ableitwiderstände der Anlage gegen Erde benutzt wird.

Eine zeitgenössischere Variante existiert beispielsweise mit dem Isolationsüberwachungsgerät Bender Isometer 685 (https://www.bender.de/fileadmin/content/Products/m/d/iso685-x-P_D00170_M_XXDE.pdf). Es ist z.B. In der Lage Kapazitäten bis 1000µF und Isolationswiderstände >10kΩ zu überwachen.

Üblich ist es, bei Geräten die sowohl für das TN-Netz (Erdung an der Stromquelle und der elektrischen Betriebsmittel (TN-C-System, TN-C-S-System, TN-S-System)) als auch für das IT-Netz vorgesehen sind, beim Betrieb im IT-Netz ein Teil der zum Schutzleiter PE (englisch: protective earth) wirkenden Filterkondensatoren abzuhängen. Dies verringert die zum Schutzleiter PE wirkende Kapazität, lässt aber noch eine Grundentstörung des Gerätes zu. Über die zum Schutzleiter PE wirkenden Kapazitäten sind hochohmige Widerstände parallelgeschaltet. Sie dienen zur definierten Entladung der genannten Kapazitäten. Um gefährliche Spannungen für Wartungspersonal zu vermeiden ist eine definierte Entladung (unter 60V) vorgeschrieben. Auch in 24V-Netzen gibt es Kapazitäten und Entladewiderstände zu PE. Hier dienen diese meist zur definierten Entladung der Kapazitäten nach einem Surge-Impuls.

Das Dokument EP3862763A1 beschreibt ein Verfahren zur Überwachung eines Erdwiderstands einer elektrischen Anlage.

Es ist dabei eine Herausforderung, insbesondere aus Sicht eines Anlagenbetreibers möglichst große Widerstandswerte und möglichst kleine Kapazitäten zu erreichen. Weiterhin ist es oft wünschenswert, möglichst viele Netzteile und Geräte mit einem Isolationswächter zu überwachen, sodass vergleichsweise weniger Isolationswächter zur Isolationsüberwachung der Gesamtanlage ausreichend sind.

Der Erfindung liegt das Problem zugrunde, die bekannten Anordnungen mit einem Isolationswächter derart auszugestalten und weiterzubilden, dass hinsichtlich der genannten Herausforderung eine weitere Optimierung erreicht wird.

Das obige Problem wird durch eine Anordnung der eingangs genannter Art mit den zusätzlichen Merkmalen des Kennzeichens des Anspruchs 1 gelöst.

Im Einzelnen ist vorgesehen, dass die Anordnung in Reihenschaltung zu dem Entladewiderstand zwei antiseriell angeordnete Z-Dioden aufweist, wobei die Z-Dioden jeweils eine Sperrspannung oberhalb einer Prüfspannung des Isolationswächters aufweisen. Nach der Erfindung wird der Entladewiderstand durch eine Reihenschaltung von antiseriell geschalteten Z-Dioden und dem Entladewiderstand ersetzt. Das definierte Entladen der Kondensatoren auf eine Spannung unter 60V bzw. nach Surge Impulsen kann weiterhin gewährleistet werden. Ggf. muss der Entladewiderstand angepasst werden. Wesentlich ist die grundsätzliche Überlegung, dass der Widerstand für den Isolationswächter infolge der erfindungsgemäßen Reihenschaltung von antiseriell geschalteten Z-Dioden zu dem Entladewiderstand ausgeblendet wird. Der Isolationswächter erzeugt während eines Testzyklus eine Prüfspannung, deren Polarität periodisch umgekehrt wird. Diese Prüfspannung betragen häufig ca. 10V. Die Z-Dioden werden hinsichtlich der Sperrspannung über diesen Spannungswert ausgewählt, sodass der gewünschte Effekt der Ausblendung des Entladewiderstands hierbei gewährleistet ist.

Im Einzelnen wird vorgeschlagen, dass die Anordnung in Reihenschaltung zu dem Entladewiderstand zwei antiseriell angeordnete Z-Dioden aufweist, wobei die Z-Dioden jeweils eine Sperrspannung oberhalb einer Prüfspannung des Isolationswächters aufweisen.

Eine vorteilhafte Weiterbildung der Erfindung sieht vor, dass parallel zu der Reihenschaltung aus dem Entladewiderstand und den zwei antiseriell angeordneten Z-Dioden, ein Entstörkondensator angeordnet ist.

Derartige Entstörkondensatoren werden zur Grundentstörung eines IT-Systems eingesetzt, um höherfrequente Störanteile aus dem System abzuleiten. Diese Ableitung eignet sich gut für die dazu parallele Anordnung der erfindungsgemäßen Reihenschaltung aus dem Entladewiderstand und den zwei antiseriell angeordneten Z-Dioden, sodass die gesamte Erdableitkapazität mittels dieser Reihenschaltung bis zur Sperrspannung der Z-Dioden entladen werden kann.

Eine vorteilhafte Weiterbildung der Erfindung sieht vor, dass parallel zu den zwei antiseriell angeordneten Z-Dioden, und in Reihe zu dem Entladewiderstand ein zusätzlicher Entladewiderstand angeordnet ist, wobei der zusätzliche Entladewiderstand einen höheren Widerstandswert aufweist als der seriell zu den zwei antiseriell angeordneten Z-Dioden angeordnete Entladewiderstand.

Der durch die Erfindung in dieser Weiterbildung gewonnene Vorteil liegt darin, dass der Isolationswächter ISG den niederohmigeren Entladewiderstand in der seriellen Anordnung zu dem antiseriellen Z-Dioden-Paar nicht "sieht", sondern nur den vergleichsweise höherohmigen zusätzlichen Entladewiderstand. Auf diese Weise findet eine quasi stufenweise Entladung statt, derart, dass Spannungen oberhalb der Sperrspannung der Z-Dioden schneller entladen werden und Spannungen unterhalb der Sperrspannung langsamer.

Im Folgenden ist die Erfindung anhand eines speziellen Ausführungsbeispiels zur Verdeutlichung näher beschrieben. Es zeigen:

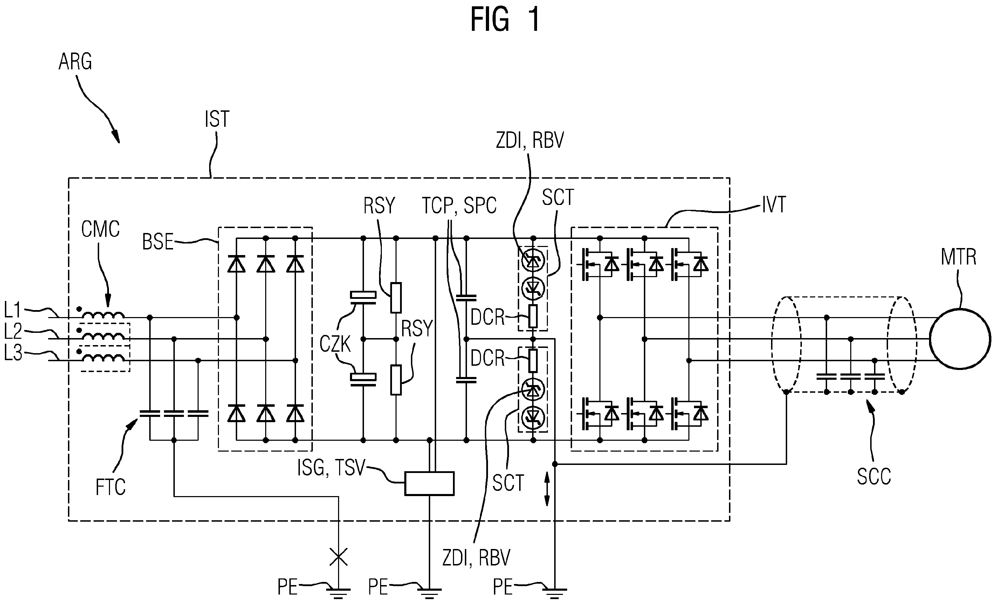

Figuren 1, 2, 3: jeweils ein schematisches Schaltbild einer ersten Ausführungsform der Erfindung.

Funktionsgleiche Bauteile sind teilweise mit identischen Bezugszeichen versehen. Funktionsgleiche Bauelemente werden teilweise nicht in allen Figuren ausgewiesen und auch nicht zu jeder einzelnen Abbildung separat wiederholt erläutert. Es ist grundsätzlich davon auszugehen, dass diese Bauelemente in den unterschiedlichen Darstellungen jeweils eine im Wesentlichen gleiche Funktion aufweisen.

Das in den Figuren 1, 2, 3 jeweils schematisch als Schaltbild dargestellte und insoweit bevorzugte Ausführungsbeispiel betrifft jeweils eine Anordnung ARG mit einem Isolationswächter ISG für ein IT-System IST und einem Entladewiderstand DCR zur Entladung einer Erd-Ableitkapazität TCP des IT-Systems IST.

Das IT-System IST wird mittels Drehstroms (Drehstromphasen L1, L2, L3) mit Leistung versorgt. Eine Gleichtaktdrossel CMC dient der Strombegrenzung in dem IT-System IST. Zur Ableitung unerwünschter Frequenzen auf Erde sind die einzelnen Drehstromphasen jeweils mit einem Filterkondensator FTC verbunden. Diese Verbindung wird getrennt, wenn die Anordnung ARG erfindungsgemäß im IT-Netz betrieben wird. Der Drehstrom wird nachfolgend gleichgerichtet mittels eines B6-Gleichrichters BSE. Zwischenkreiskondensatoren CZK ermöglichen die Entfernung unerwünschter Frequenzen nach der Gleichrichtung.

Ausgangs der Anordnung ist ein Verbraucher angeschlossen, der hier als Motor MTR mit einem geschirmten Motorkabel SCC an einem Leistungsschalter IVT angeschlossen ist.

Das Schaltbild zeigt Erd-Ableitkapazitäten TCP. Diese Erd-Ableitkapazitäten TCP illustrieren vorliegend die Kapazität des IT-Systems IST gegen die Erde PE und können auch Entstörkondensatoren SPC umfassen. Zur sicheren Entladung der Erd-Ableitkapazitäten TCP ist an den Gleichstromleitungen jeweils ein Entladewiderstand DCR - also parallel zu den Erd-Ableitkapazität TCP - vorgesehen. Damit der Isolationswächter ISG diese Entladewiderstände DCR bei einem Prüflauf mit einer TSV Prüfspannung mit wechselnder Polarität nicht mit misst, ist erfindungsgemäß vorgesehen, dass jeweils in Reihenschaltung SCT zu dem Entladewiderstand DCR zwei antiseriell angeordnete Z-Dioden ZDI geschaltet sind, wobei die Z-Dioden ZDI jeweils eine Sperrspannung RBV oberhalb einer Prüfspannung TSV des Isolationswächters ISG aufweisen.

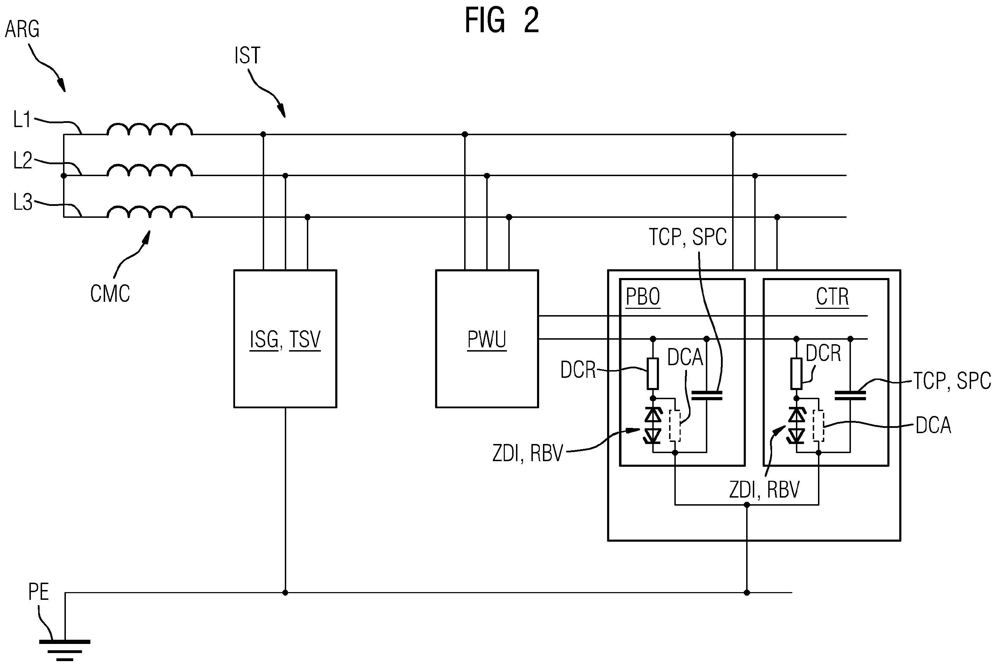

Die Anordnung ARG, die in der Figur 2 vereinfacht dargestellt ist, ist grundsätzlich ähnlich und sieht einen Umrichtergesteuerten Servomotor vor, beispielsweise ein Servo-Antriebssystem SINAMICS S210 der Firma Siemens. Der dargestellte Umrichter CVT umfasst eine Leistungseinheit PBO und eine Steuerungseinheit CTR. Diese Komponenten des Umrichters CVT werden mit einer gleichgerichteten Spannung mittels eines 24V-Netzteils versorgt. Ein Isolationswächter ISG ist in dem dargestellten IT-System IST zur Überwachung auf Erdschlüsse zwischen der Erde PE und den Drehstromphasen L1, L2, L3 angeschlossen.

Für jede Komponente des Umrichters CVT ist eine jeweilige Erd-Ableitkapazität TCP mit einem parallel geschalteten Entladewiderstand DCR versehen, wobei erfindungsgemäß vorgesehen ist, dass jeweils in Reihenschaltung SCT zu dem Entladewiderstand DCR zwei antiseriell angeordnete Z-Dioden ZDI geschaltet sind, wobei die Z-Dioden ZDI jeweils eine Sperrspannung RBV oberhalb einer Prüfspannung TSV des Isolationswächters ISG aufweisen. Zur Vermeidung unbestimmter Potenziale zwischen der Reihenschaltung SCT des Z-Diodenpaares und dem Entladewiderstand DCR ist in Reihe zu dem Entladewiderstand DCR ein zusätzlicher Entladewiderstand DRA angeordnet. Der zusätzliche Entladewiderstand DRA weist einen höheren Widerstandswert auf als der seriell zu den zwei antiseriell angeordneten Z-Dioden ZDI angeordnete Entladewiderstand DCR. Der Isolationswächter sieht dadurch jeweils nur den höheren Widerstandswert des zusätzliche Entladewiderstand DRA, wobei eine schnelle Entladung durch den niederohmigeren Entladewiderstand DCR gewährleistet ist.

Der jeweilige Entladewiderstand kann nach Bedarf angepasst werden. Der Widerstand wird erfindungsgemäß für den Isolationswächter ISG "ausgeblendet", beziehungsweise der von dem Isolationswächter ISG gemessene Widerstand ist gegenüber dem tatsächlichen Entladewiderstand signifikant erhöht. Die einstellbaren Messspannungen des Isolationswächters ISG liegen je nach Modus typischerweise zwischen 10V-60V liegen. Diese Prüfspannung TSV liegt während der Messung mit wechselnder Polarität an. In folgender Tabelle sind Messergebnisse mit verschiedenen Kombinationen im DC-Leistungsmodus (Messpannung des Bender Isometer 685 = 50V, Konfiguration gemäß Figur 1) wiedergegeben:

| Verwendeter Entladewiderstand [kΩ] | Verwendete Z-Dioden | Gemessener Widerstand Isometer 685 [kΩ] |
|---|---|---|
| offen | offen | >10000 |
| 18 | keine | 18 |
| 18 | 30V Z-Diode | 335 |
| 330 | keine | 330 |
| 330 | 24V Z-Diode | 780 |
| keiner | 15V Z-Diode | 81 |

Die Messergebnisse zeigen, dass durch den Einsatz der Z-Dioden der mit dem Isolationswächter gemessene Widerstand deutlich ansteigt.

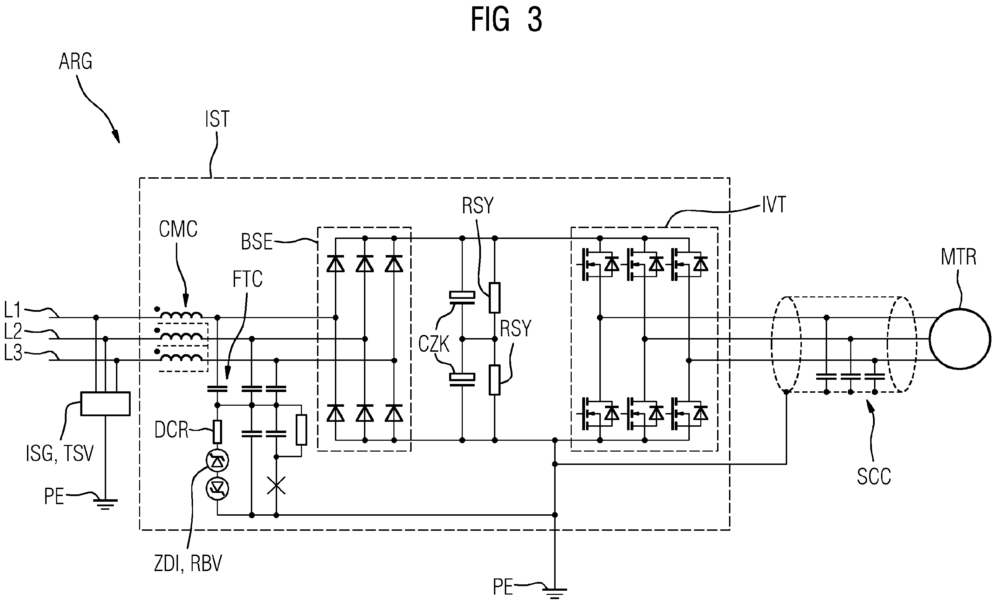

Figur 3 zeigt schematisch als Schaltbild dargestellte Anordnung ARG mit einem Isolationswächter ISG für ein IT-System IST und einem Entladewiderstand DCR zur Entladung einer Erd-Ableitkapazität TCP des IT-Systems IST in einer Grundkonfiguration. Die Anordnung ARG und deren Funktion entspricht derjenigen der Figur 1 mit dem Unterschied, dass der Isolationswächter ISG vor der Gleichtaktdrossel CMC des IT-Systems IST angeschlossen ist. Auf diese Weise wird ein größerer Bereich der dargestellten Schaltung als IT-System betrieben und mittels des Isolationswächters ISG überwacht. Die durchgestrichene Leitung im Bereich der drei Filterkondensatoren FTC symbolisiert eine Leitungstrennung, wenn die Anordnung ARG als IT-System IST betrieben wird.

Unabhängig vom grammatikalischen Geschlecht eines bestimmten Begriffes sind Personen mit männlicher, weiblicher oder anderer Geschlechteridentität in diesem Dokument mit umfasst.

## Patentansprüche

1. Anordnung (ARG) mit einem Isolationswächter (ISG) für ein IT-System (IST) und einem Entladewiderstand (DCR) zur Entladung einer Erd-Ableitkapazität (TCP) des IT-Systems (IST),
**dadurch gekennzeichnet, dass**
die Anordnung (ARG) in Reihenschaltung (SCT) zu dem Entladewiderstand (DCR) zwei antiseriell angeordnete Z-Dioden (ZDI) aufweist, wobei die Z-Dioden (ZDI) jeweils eine Sperrspannung (RBV) oberhalb einer Prüfspannung (TSV) des Isolationswächters (ISG) aufweisen.

2. Anordnung (ARG) nach Anspruch 1, wobei parallel zu der Reihenschaltung (SCT) aus dem Entladewiderstand (DCR) und den zwei antiseriell angeordnete Z-Dioden (ZDI), ein Entstörkondensator (SPC) angeordnet ist.

3. Anordnung (ARG) nach Anspruch 1 oder 2, wobei parallel zu den zwei antiseriell angeordneten Z-Dioden (ZDI), und in Reihe zu dem Entladewiderstand (DCR) ein zusätzlicher Entladewiderstand (DRA) angeordnet ist, wobei der zusätzliche Entladewiderstand (DRA) einen höheren Widerstandswert aufweist als der seriell zu den zwei antiseriell angeordneten Z-Dioden (ZDI) angeordnete Entladewiderstand (DCR) .

4. IT-System (IST) mit einer Anordnung (ARG) nach einem der vorhergehenden Ansprüche.

## Claims

1. Arrangement (ARG) with an insulation monitor (ISG) for an IT system (IST) and a discharge resistor (DCR) for discharging an earth dissipation capacitor (TCP) of the IT system (IST),
**characterised in that**
the arrangement (ARG) has two Zener diodes (ZDI) arranged in anti-series in a series connection (SCT) with the discharge resistor (DCR), wherein the Zener diodes (ZDI) each have a reverse voltage (RBV) above a test voltage (TSV) of the insulation monitor (ISG).

2. Arrangement (ARG) according to claim 1, wherein an interference suppression capacitor (SPC) is arranged in parallel with the series connection (SCT) consisting of the discharge resistor (DCR) and the two Zener diodes (ZDI) arranged in anti-series.

3. Arrangement (ARG) according to claim 1 or 2, wherein an additional discharge resistor (DRA) is arranged in parallel with the two Zener diodes (ZDI) arranged in anti-series, and in series with the discharge resistor (DCR), wherein the additional discharge resistor (DRA) has a higher resistance value than the discharge resistor (DCR) arranged in series with the two Zener diodes (ZDI) arranged in anti-series.

4. IT system (IST) with an arrangement (ARG) according to one of the preceding claims.

## Revendications

1. Montage (ARG) comprenant un isolateur (ISG) **d'isolation** pour un système isolé-terre (IST) et une résistance (DCR) de décharge pour la décharge d'une capacité à la terre (TCP) du système IT (IST),
**caractérisé en ce que**
le montage (ARG) a deux diodes Z (ZDI) montées tête-bêche en un montage (SCT) série avec la résistance (DCR) de décharge, dans lequel les diodes Z (ZDI) ont chacune une tension (RBV) de blocage au-dessus d'une tension (TSV) de contrôle du contrôleur (ISG) d'isolation.

2. Montage (ARG) suivant la revendication 1, dans lequel un condensateur (SPC) antiparasite est monté en parallèle au montage (SCT) série composé de la résistance (DCR) de décharge et des deux diodes Z (ZDI) montées tête-bêche.

3. Montage (ARG) suivant la revendication 1 ou 2, dans lequel une résistance (DRA) de décharge supplémentaire est montée en parallèle avec les deux diodes Z (ZDI) montées tête-bêche et en série avec la résistance (DCR) de décharge, dans lequel la résistance (DRA) de décharge supplémentaire a une valeur de résistance plus grande que la résistance (DCR) de décharge montée en série avec les deux diodes Z (ZDI) montées tête-bêche.

4. Système isolé-terre (IST) comprenant un montage (ARG) suivant l'une des revendications précédentes.
